# EUROPEAN PATENT APPLICATION

(11) **EP 3 522 235 A1**
(43) Date of publication of application: **07.08.2019**
(21) Application number: 17856456.3
(22) Date of filing: 29.09.2017
(51) Int. Cl.: H01L 31/048, H02S 40/34

(54) **SOLAR CELL MODULE**

(30) Priority: 30.09.2016 JP 2016193659
(71) Applicant: Kyocera Corporation, Kyoto-shi Kyoto 612-8501 (JP)
(72) Inventor: ARANAMI, Junji, Kyoto-shi Kyoto 612-8501 (JP); MIYAMICHI, Yusuke, Kyoto-shi Kyoto 612-8501 (JP); TAKAHASHI, Eigo, Kyoto-shi Kyoto 612-8501 (JP)
(74) Representative: Viering, Jentschura & Partner mbB Patent- und Rechtsanwälte
(86) International application number: PCT/JP2017/035550
(87) International publication number: WO 2018/062509

(57) **Abstract**

A solar cell module includes a first plate part, a second plate part, a solar cell section, a wiring material, a first sealing material, and a second sealing material. The second plate part is positioned in a state of facing the first plate part. The solar cell section is positioned in a gap between the first plate part and the second plate part. The wiring material is electrically connected to the solar cell section and is positioned from an inside of the gap to an outside of the gap via a through hole that is present in the first plate part. The first sealing material is positioned in a region covering the solar cell section in the gap. The second sealing material is in a state of being filled in an annular region that is closer to the through hole than the first sealing material in the gap and surrounds the entire periphery of the through hole in plan perspective view, and has a higher water barrier property than the first sealing material. Then, at least one of the first plate part and the second plate part has a light-transmitting property for light having a wavelength in a specific range.

## Description

### Technical Field

The present disclosure relates to a solar cell module.

### Background Art

There are solar cell modules in which an extraction electrode to extract charges generated in a solar cell extends to an outside via a through hole of a substrate that is for protection of one surface of the solar cell (e.g., refer to description of Japanese Patent Application Laid-Open No. 2013-89751).

### Summary

A solar cell module is disclosed.

One aspect of a solar cell module includes a first plate part, a second plate part, a solar cell section, a wiring material, a first sealing material, and a second sealing material. The second plate part is positioned in a state of facing the first plate part. The solar cell section is positioned in a gap between the first plate part and the second plate part. The wiring material is electrically connected to the solar cell section and is positioned from an inside of the gap to an outside of the gap via a through hole that is present in the first plate part. The first sealing material is positioned in a region covering the solar cell section in the gap. The second sealing material is in a state of being filled in an annular region that is closer to the through hole than the first sealing material in the gap and surrounds the entire periphery of the through hole in plan perspective view, and has a higher water barrier property than the first sealing material. At least one of the first plate part and the second plate part has a light-transmitting property for light having a wavelength in a specific range.

### Brief Description of Drawings

Fig. 1 is a perspective view showing a configuration of one example of a solar cell module according to a first embodiment.
Fig. 2 is an end view showing one example of a cross section of the solar cell module taken along line II-II of Fig. 1.
Fig. 3 is an enlarged end view showing a configuration of a part of the solar cell module in a first region A1 of Fig. 2.
Fig. 4 is a perspective view showing one example of a configuration of a part of a periphery of a through hole of the solar cell module.
Fig. 5 is a flowchart showing a flow according to one example of a method for manufacturing the solar cell module.
Fig. 6 is a perspective view showing one example of a state in middle of manufacturing the solar cell module.
Fig. 7 is a perspective view showing one example of a state in middle of manufacturing the solar cell module.
Fig. 8 is a perspective view showing one example of a state in middle of manufacturing the solar cell module.
Fig. 9 is a perspective view showing one example of a state in middle of manufacturing the solar cell module.
Fig. 10 is a perspective view showing one example of a state in middle of manufacturing the solar cell module.
Fig. 11 is a perspective view showing one example of a state in middle of manufacturing the solar cell module.
Fig. 12 is an end view showing a cross section corresponding to a cross section taken along line II-II of Fig. 1 in a configuration of one example of the solar cell module mounted with a frame.
Fig. 13 is an enlarged end view showing one example of a configuration of a region corresponding to a first region A1 of Fig. 2 in a solar cell module according to a second embodiment.
Fig. 14 is an end view showing a cross section corresponding to a cross section taken along line II-II of Fig. 1 in a configuration of one example of a solar cell module mounted with a frame, according to a third embodiment.
Fig. 15 is an enlarged end view showing one example of a configuration of a region corresponding to a first region A1 of Fig. 2 in the solar cell module according to the third embodiment.

### Description of Embodiments

There are solar cell modules in which one surface of a solar cell is joined with a protective substrate such as glass for protection of the solar cell. Such a solar cell module is produced, for example, by forming a photoelectric conversion body on one surface of a substrate, disposing a collector electrode on this photoelectric conversion body, disposing an extraction electrode having a first end part connected to the collector electrode on this photoelectric conversion body, covering the photoelectric conversion body with a seal member, and disposing a protective substrate on this sealing member. At this time, for example, it is conceivable to position a second end part of the extraction electrode in a state of extending to a side opposite to a region where the photoelectric conversion body is present, through an opening present in the protection substrate, and to position the sealing member so as to close the opening. Here, for example, polyisobutylene resin or butyl resin can be used as the sealing member. Further, as the sealing member, for example, an ethylene-vinyl acetate copolymer (EVA) or the like can be used.

Meanwhile, with regard to solar cell modules, life extension in which a stable output is maintained for a long period of time is pursued. Therefore, the present inventors have created a technique that can enhance long-term reliability of the solar cell module.

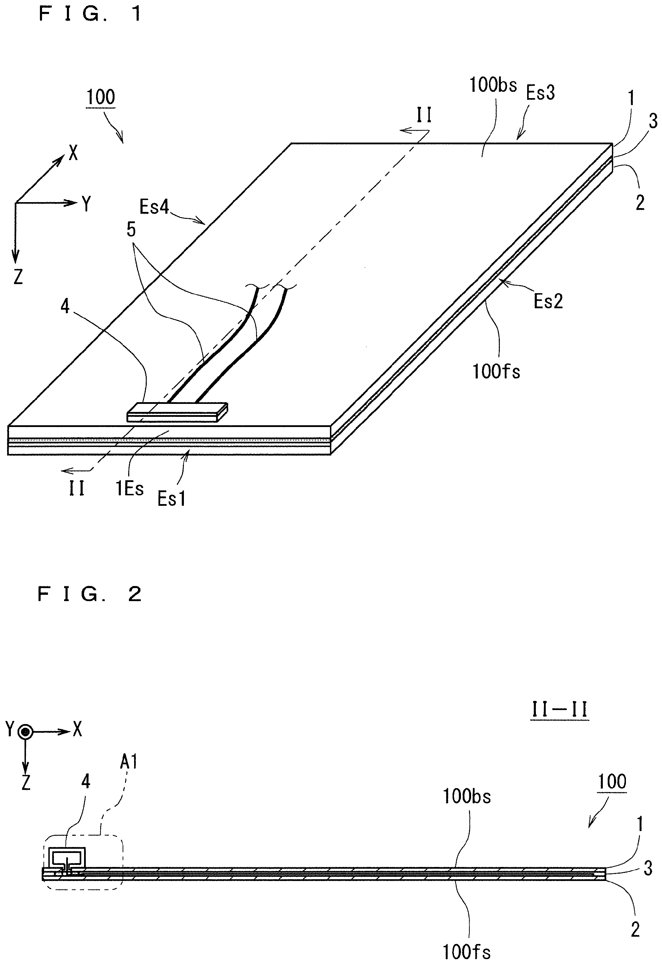

Regarding this, each embodiment will be described with reference to the drawings below. In the drawings, the same reference numerals are given to portions having similar configurations and functions, and redundant explanations are omitted in the following description. Further, the drawings are schematically shown. In Figs. 1 to 4 and Figs. 6 to 15, a right-handed XYZ coordinate system is given. In this XYZ coordinate system, a direction along a long side of a solar cell module 100 is defined as a +X direction, a direction along a short side of the solar cell module 100 is defined as a +Y direction, and a direction orthogonal to both the +X direction and the +Y direction is defined as a +Z direction. In other words, a direction along a thickness direction of the solar cell module 100 is defined as the +Z direction.

### <1. First Embodiment>

### <1-1. Configuration of Solar Cell Module>

A configuration of a solar cell module 100 according to a first embodiment will be described with reference to Figs. 1 to 4. As shown in Figs. 1 to 3, the solar cell module 100 includes a first plate part 1, a second plate part 2, a protected part 3, a terminal box 4, and an output wiring 5. In the present embodiment, a board surface of the second plate part 2 on the +Z direction side is defined as a surface (also referred to as a front surface) 100fs that is mainly irradiated with external light such as sunlight. Further, a board surface of the first plate part 1 on the -Z direction side is defined as a surface (also referred to as a back surface) 100bs that is irradiated with less external light such as sunlight than the front surface 100fs.

For example, the first plate part 1 can protect the protected part 3. A shape of the first plate part 1 is, for example, a flat plate shape. Specifically, for example, a flat plate having a board surface with a rectangular shape such as an oblong may be adopted as the first plate part 1. For example, the first plate part 1 may have a light-transmitting property for light having a wavelength in a specific range, or may not have a light-transmitting property for light having a wavelength in a specific range.

For example, when glass or a resin such as acrylic or polycarbonate having a thickness of about 1 mm or more and 5 mm or less is adopted as a material of the first plate part 1, the first plate part 1 having a water barrier property is realized. This may reduce entry of moisture from the outside of the solar cell module 100 to the protected part 3. At this time, for example, the first plate part 1 having a light-transmitting property for light having a wavelength in a specific range may also be realized. This allows, for example, light irradiated to the back surface 100bs and transmitted through the first plate part 1 to be incident on the protected part 3, and to be used for photoelectric conversion in a solar cell section 3pv in the protected part 3. As a result, for example, an output in the solar cell module 100 may be improved. Light to be incident on the back surface 100bs may be generated, for example, by reflection of sunlight on the ground or the like. Further, as a material of the first plate part 1, for example, ceramics or the like not having a light-transmitting property for light having a wavelength in a specific range may be adopted. As a wavelength in a specific range in this specification, for example, there is adopted a wavelength in a range of light that may be photoelectrically converted by the solar cell section 3pv in the protected part 3. When a wavelength of light having a high irradiation intensity constituting sunlight is included in the wavelength in the specific range, photoelectric conversion efficiency in the solar cell section 3pv may be improved.

In the first plate part 1, there is a through hole 1h. This through hole 1h is for outputting electric charges obtained by photoelectric conversion in the solar cell section 3pv to the outside of the solar cell module 100. The through hole 1h penetrates, for example, the first plate part 1 in a thickness direction of this first plate part 1. For example, the through hole 1h is present at a position close to one end face 1Es of the first plate part 1, such as a position apart from this one end face 1Es by about 10 mm or more and 40 mm or less. The through hole 1h may be formed in the first plate part 1 by a drill for boring, a jet water stream, or the like.

In the first embodiment, for example, there are the through hole 1h for a positive electrode and the through hole 1h for a negative electrode. Then, a cross section perpendicular to a direction (also referred to as a penetration direction) penetrating through the first plate part 1 in the through hole 1h is a substantially perfect circle. In the example of Figs. 1 to 4, the penetration direction is the +Z direction. Further, for example, a shape and a size of the cross section perpendicular to the penetration direction of the through hole 1h are made substantially constant irrespective of the position in this penetration direction. The shape of the cross section perpendicular to the penetration direction of the through hole 1h may be, for example, a shape other than a perfect circle, such as a polygonal shape including a quadrangle or a hexagon, or an elliptical shape. Here, for example, at least one of the shape and the size of the cross section perpendicular to the penetration direction of the through hole 1h may be slightly changed in this penetration direction.

The second plate part 2 is, for example, positioned in a state of facing the first plate part 1. Then, the protected part 3 is positioned in a gap 3g between the first plate part 1 and the second plate part 2. Therefore, the second plate part 2 can protect the protected part 3 together with the first plate part 1. A distance that the first plate part 1 and the second plate part 2 are separated from each other with the gap 3g interposed in between is, for example, about 0.5 mm or more and 5 mm or less. A shape of the second plate part 2 is, for example, a flat plate shape similar to that of the first plate part 1. Specifically, for example, a flat plate having a board surface of a rectangular shape such as an oblong may be adopted as the second plate part 2. In the first embodiment, the second plate part 2 has the same outer shape as the first plate part 1.

Further, the second plate part 2 has a light-transmitting property for light having a wavelength in a specific range. Therefore, for example, light irradiated on the front surface 100fs and transmitted through the second plate part 2 may be incident on the protected part 3, and may be used for photoelectric conversion in the solar cell section 3pv included in the protected part 3.

For example, when glass or resin such as acrylic or polycarbonate is adopted as a material of the second plate part 2, it is possible to realize the second plate part 2 having a water barrier property capable of reducing entry of moisture from the outside of the solar cell module 100 to the protected part 3. At this time, for example, the second plate part 2 having a light-transmitting property for light having a wavelength in a specific range may also be realized. As the glass, for example, a material with high light transmittance, such as white plate glass, tempered glass, and heat ray reflecting glass having a thickness of about 1 mm or more and 5 mm or less may be adopted.

The protected part 3 includes the solar cell section 3pv, a wiring material 3t, a first sealing material 3fi, and a second sealing material 3se. Therefore, the solar cell section 3pv is positioned in the gap 3g between the first plate part 1 and the second plate part 2. For example, the solar cell section 3pv may be formed on the second plate part 2 or the first plate part 1, or may be positioned so as to be sandwiched between the first plate part 1 and the second plate part 2.

The solar cell section 3pv includes N pieces of (N is an integer of 1 or more) solar cell element capable of converting incident sunlight into electricity, for example. As the solar cell element, for example, a crystalline solar cell element or a thin film solar cell element may be adopted. As the crystalline solar cell element, for example, there may be adopted a silicon solar cell element such as single crystal silicon, polycrystalline silicon, or a heterojunction type, or a compound solar cell element such as III-V group. Further, as the thin film solar cell element, for example, a silicon solar cell element, a compound solar cell element, or other type of solar cell element may be adopted. The silicon solar cell element in the thin film system may include, for example, a solar cell element using amorphous silicon and thin-film polycrystalline silicon. The compound solar cell element in the thin film system may include, for example, a solar cell element using a compound semiconductor such as a CIS semiconductor, a CIGS semiconductor, a cadmium telluride (CdTe) semiconductor, or a compound having a perovskite structure. The CIS semiconductor is a compound semiconductor containing cadmium (Cd), indium (In), and selenium (Se). The CIGS semiconductor is a compound semiconductor containing cadmium (Cd), indium (In), gallium (Ga), and selenium (Se). Other types of solar cell elements in thin film system may include, for example, a solar cell element of a type such as an organic thin film or dye sensitization. Here, for example, in a case where N pieces of solar cell element are electrically connected in series, an output of the solar cell module 100 may be larger as N is larger. In the first embodiment, the solar cell section 3pv including a plurality of thin film solar cell elements is formed on the second plate part 2.

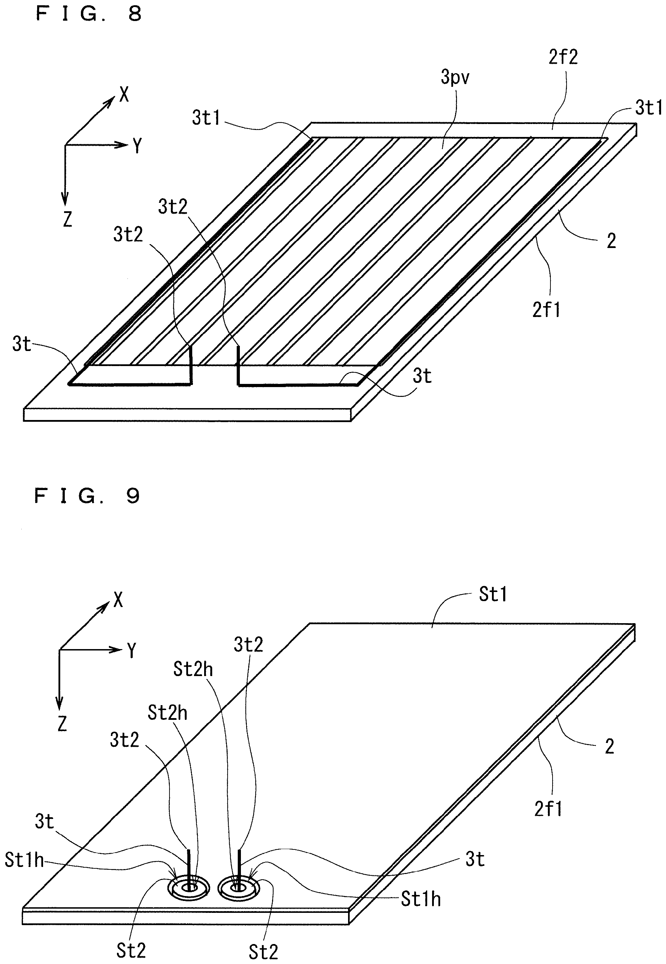

The wiring material 3t is electrically connected to the solar cell section 3pv. This wiring material 3t is positioned in a state of extending from inside the gap 3g between the first plate part 1 and the second plate part 2 to outside the gap 3g, via the through hole 1h that is present in the first plate part 1. In other words, a first end part 3t1 (see Fig. 8) in a longitudinal direction of the wiring material 3t is electrically connected to the solar cell section 3pv. A second end part 3t2 (see Figs. 8 to 10) opposite to the first end part 3t1 in the longitudinal direction of the wiring material 3t is positioned on a side opposite to the second plate part 2 in the first plate part 1. As the wiring material 3t, for example, one having a belt-like shape may be adopted. As a material of the wiring material 3t, for example, metal or the like having conductivity, such as copper, may be adopted. Here, for example, as the wiring material 3t, there may be adopted one with a belt shape having a thickness of about 0.1 mm or more and 0.5 mm or less and a width of about 2 mm or more and 5 mm or less. In this way, in a case where the width of the wiring material 3t is several mm, for example, an error is unlikely to occur in a process of bending and passing the wiring material 3t into the through hole 1h, as long as a diameter of the through hole 1h is about 5 mm. Further, for example, when solder is coated on the entire surface of the wiring material 3t, the wiring material 3t may be easily joined to the solar cell section 3pv or the like. The wiring material 3t is electrically connected to the solar cell section 3pv, for example, by joining by soldering.

The first sealing material 3fi is positioned in a second region A2 covering at least the solar cell section 3pv, in the gap 3g between the first plate part 1 and the second plate part 2. As the second region A2, for example, there may be adopted such a region that covers the entire surface of the first plate part 1 side (the -Z direction side) of the solar cell section 3pv positioned on the second plate part 2. The first sealing material 3fi can seal the solar cell section 3pv by covering this solar cell section 3pv. Further, by filling the gap 3g with the first sealing material 3fi over a wide range of the gap 3g, moisture and the like are unlikely to enter the solar cell section 3pv. As a material of the first sealing material 3fi, for example, there may be adopted an ethylene-vinyl acetate copolymer (EVA), triacetyl cellulose (TAC), a polyester resin such as polyethylene naphthalate, or the like, having an excellent light-transmitting property for light having a wavelength in a specific range. For example, the first sealing material 3fi may be made of two or more kinds of sealing materials.

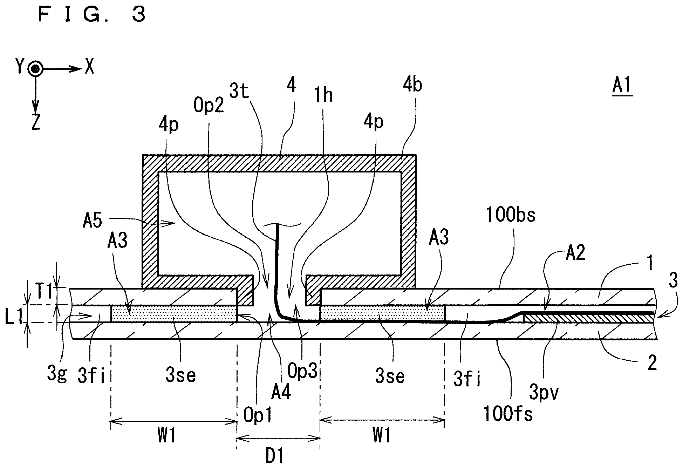

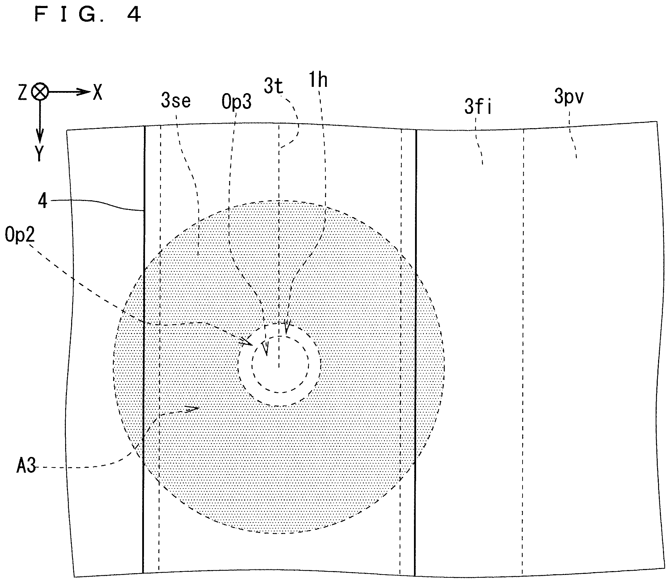

The second sealing material 3se is in a state of being filled in a third region A3 that is closer to the through hole 1h than the first sealing material 3fi in the gap 3g between the first plate part 1 and the second plate part 2. As shown in Fig. 4, the third region A3 is a region having an annular shape (also referred to as an annular region) surrounding the entire periphery of the through hole 1h in plan perspective view. In the example of Figs. 3 and 4, for example, in the third region A3, a region from the first plate part 1 to the second plate part 2 excluding a region where the wiring material 3t is positioned is filled with the second sealing material 3se. Therefore, a state is realized where the third region A3 is filled with the second sealing material 3se. The second sealing material 3se has a higher water barrier property than the first sealing material 3fi. This allows, for example, the second sealing material 3se to seal a portion (also called a first opening) Op1 that opens to a fourth region A4 between the through hole 1h and the second plate part 2, in the gap 3g between the first plate part 1 and the second plate part 2. At this time, in a path leading to the solar cell section 3pv from the opening (also referred to as a second opening) Op2 that opens toward a side opposite to the second plate part 2 in the through hole 1h, the narrowed first opening Op1 is sealed with the second sealing material 3se having a high water barrier property. Therefore, entry of moisture or the like from the outside of the solar cell module 100 via the through hole 1h of the first plate part 1 toward the solar cell section 3pv may be reduced. As a result, long-term reliability of the solar cell module 100 can be enhanced. As a material of the second sealing material 3se, for example, a butyl resin, a polyisopropylene resin, or the like may be adopted.

Here, for example, as shown in Fig. 3, when a thickness W1 of the annular third region A3 is larger than a length T1 of the through hole 1h, entry of moisture or the like from outside via the through hole 1h of the first plate part 1 toward the solar cell section 3pv may be further reduced than that in a case where the through hole 1h is directly closed with the sealing material. As a result, long-term reliability of the solar cell module 100 can be enhanced. Here, for example, in a case where the radial thickness W1 of the annular third region A3 fluctuates in a circumferential direction, it suffices that a minimum value of the thickness W1 of the third region A3 is larger than the length T1 of the through hole 1h in the penetration direction. In the first embodiment, for example, the thickness W1 of the third region A3 is 10 mm, and the length T1 of the through hole 1h is 2 mm. Here, a value (W1/T1) obtained by dividing the thickness W1 by the length T1 is, for example, 2 or more and 10 or less. At this time, for example, sufficient sealing with the second sealing material 3se and sufficient securing of the third region A3 where the second sealing material 3se is positioned may be easily achieved.

In addition, here, for example, in the gap 3g between the first plate part 1 and the second plate part 2, an area of the first opening Op1 that opens toward the fourth region A4 between the through hole 1h and the second plate part 2 is defined as S1. Further, here, for example, an area of the second opening Op2 that opens toward a side opposite to the second plate part 2 in the through hole 1h is defined as S2. In this case, for example, when the area S1 is smaller than the area S2, for example, in a path leading to the solar cell section 3pv from the second opening Op2 of the through hole 1h, the narrowed first opening Op1 may be sealed with the second sealing material 3se having a high water barrier property. This may reduce entry of moisture or the like from the outside of the solar cell module 100 via the through hole 1h of the first plate part 1 toward the solar cell section 3pv. As a result, long-term reliability of the solar cell module 100 can be enhanced. In the first embodiment, for example, a distance L1 between the first plate part 1 and the second plate part 2 is about 1 mm, and a diameter D1 of the through hole 1h is about 5 mm. At this time, the area S1 (= 5π mm² = 5 mm × π × 1 mm) is smaller than the area S2 (6.25π mm² = π × 2.5 mm × 2.5 mm).

The terminal box 4 is positioned on the back surface 100bs as a surface opposite to the second plate part 2 in the first plate part 1. The terminal box 4 is what is called a so-called junction box. The wiring material 3t is present in a state of extending into the terminal box 4 via an opening (also referred to as a third opening) Op3 of the terminal box 4. Then, the second end part 3t2 of the wiring material 3t is connected to a terminal, for example, in a fifth region A5 in the terminal box 4. The terminal box 4 is fixed to the back surface 100bs. The terminal box 4 may be fixed to the back surface 100bs with use of resin such as silicon sealant, for example. Here, the terminal box 4 is positioned so as to cover the through hole 1h from the back surface 100bs side. At this time, for example, when the terminal box 4 includes a resin casing 4b with a high water barrier property, and resin or the like is closing between this casing and the back surface 100bs, passage of moisture and the like from the outside of the solar cell module 100 toward the through hole 1h may be reduced.

Here, as shown in Fig. 3, for example, a configuration is conceivable in which the terminal box 4 includes a protrusion 4p positioned in a state of being fitted in the through hole 1h. When this configuration is adopted, positional alignment of the terminal box 4 may be performed easily by fitting the protrusion 4p into the through hole 1h, for example, in mounting the terminal box 4 to the back surface 100bs. Further, here, suppose a case where some object collides with the terminal box 4 in carrying the solar cell module 100. In this case, for example, a force may be applied to the terminal box 4 in a direction crossing the penetration direction of the through hole 1h. At this time, for example, when the protrusion 4p is positioned in a state of being fitted in the through hole 1h, a problem that the terminal box 4 falls off from the solar cell module 100 is unlikely to occur. As a result, long-term reliability of the solar cell module 100 can be enhanced.

The output wiring 5 can output electricity obtained through the solar cell module 100 to the outside. Here, the output wiring 5 is electrically connected to the wiring material 3t in the fifth region A5 in the terminal box 4. Then, the output wiring 5 is present in a state of extending from the fifth region A5 in the terminal box 4 to the outside of the terminal box 4.

Four end faces Es1, Es2, Es3, and Es4 of the solar cell module 100 may be mounted with, for example, a frame made of aluminum or the like. At this time, when a resin having an excellent water barrier property, such as a butyl resin, is filled between the frame and the end faces Es1, Es2, Es3, and Es4, entry of moisture and the like from the end faces Es1, Es2, Es3, and Es4 of the solar cell module 100 toward the solar cell section 3pv may be reduced. As a result, long-term reliability of the solar cell module 100 may be enhanced.

### <1-2. Method for Manufacturing Solar Cell Module>

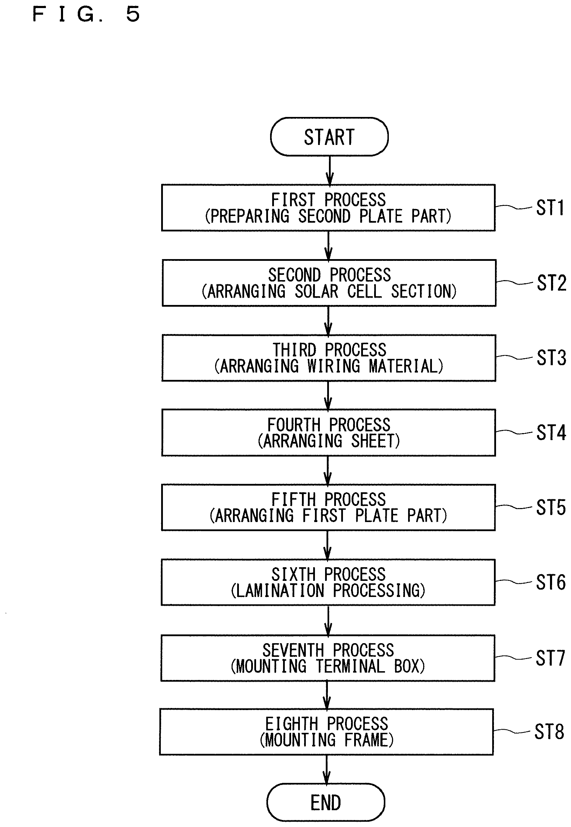

One example of a method for manufacturing the solar cell module 100 will be described with reference to Figs. 5 to 12. Here, the solar cell module 100 can be manufactured by performing a first process to an eighth process of steps ST1 to ST8 shown in Fig. 5 in this described order.

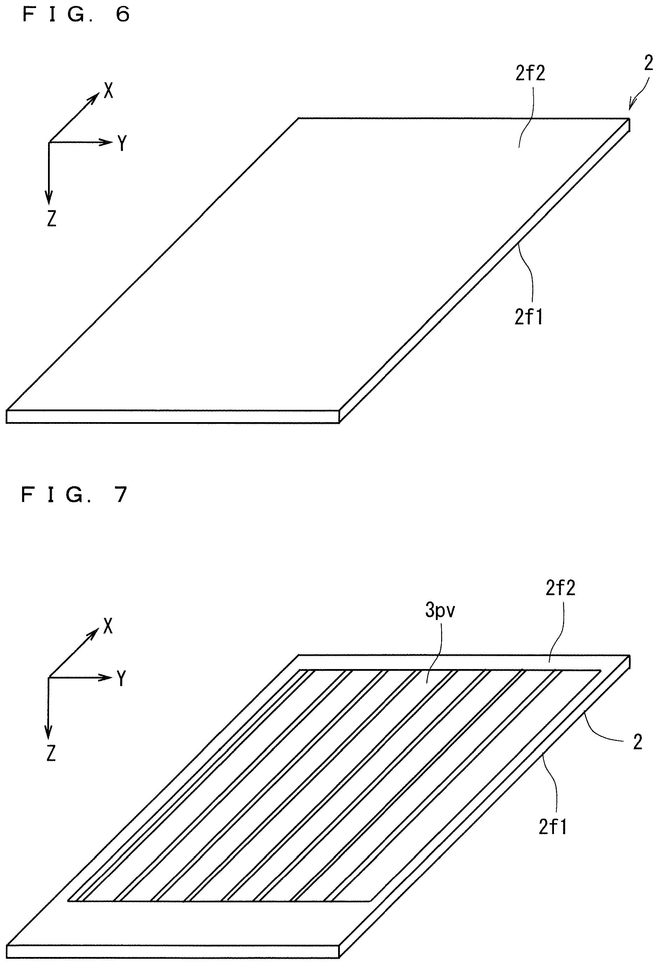

In step ST1, the first process of preparing the second plate part 2 is performed. Here, for example, as shown in Fig. 6, a flat-plate-shaped glass plate or the like having a first face 2f1 and a second face 2f2 that have a rectangular shape is prepared as the second plate part 2.

Next, in step ST2, the second process of arranging the solar cell section 3pv is performed. Here, for example, as shown in Fig. 7, the solar cell section 3pv is arranged on the second face 2f2 of the second plate part 2. At this time, for example, a thin film photoelectric conversion element or the like as the solar cell section 3pv may be formed on this second plate part 2 with the second plate part 2 as a substrate, or the solar cell section 3pv including one or more already manufactured photoelectric conversion elements may be placed on the second plate part 2. In the example of Fig. 7, the solar cell section 3pv in which eight thin film solar cell elements are connected in series is formed on the second plate part 2.

Next, in step ST3, the third process of arranging the wiring material 3t is performed. Here, for example, as shown in Fig. 8, one wiring material 3t is joined to a positive electrode of the solar cell section 3pv, and another wiring material 3t is joined to a negative electrode of the solar cell section 3pv. Joining of the wiring material 3t to the solar cell section 3pv is performed by, for example, soldering or the like. In addition, here, the wiring material 3t may be arranged along a desired path by being bent appropriately. Here, the wiring material 3t may be bent at a desired position, for example, before being joined to the solar cell section 3pv. At this time, for example, in the wiring material 3t, there is formed a portion positioned in a state of extending in the - Z direction for insertion via the through hole 1h of the first plate part 1.

Next, in step ST4, the fourth process of arranging a sheet to be a sealing material is performed. Here, for example, as shown in Fig. 9, a sheet (also referred to as a first sheet) St1 made of a resin (such as EVA) to be the first sealing material 3fi is arranged in such a region that covers the solar cell section 3pv. Further, at this time, on the second plate part 2, an annular sheet (also referred to as a second sheet) St2 made of resin (butyl resin or the like) to be the second sealing material 3se is arranged in each of two circular through holes St1h of the first sheet St1. At this time, the wiring material 3t is in a state of being inserted through a through hole St2h of each second sheet St2 in the-Z direction.

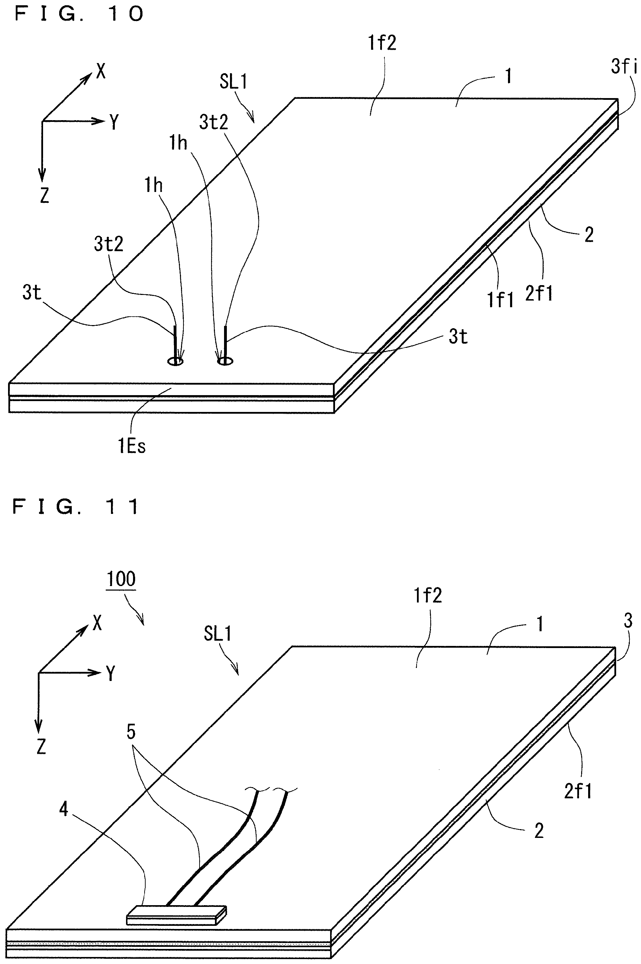

Next, in step ST5, the fifth process of arranging the first plate part 1 is performed. Here, for example, as shown in Fig. 10, the first plate part 1 is stacked on the first sheet St1 and the second sheet St2. At this time, the wiring material 3t is in a state of being inserted through each of the two through holes 1h of the first plate part 1 in the -Z direction. Here, for example, as the first plate part 1, there is used a flat-plate-shaped glass plate or the like having a first face 1f1 and a second face 1f2 that have a rectangular shape, and having two through holes 1h near the one end face 1Es. This allows formation of a laminate SL1 in which two wiring materials 3t are arranged, and the second plate part 2, the solar cell section 3pv, the first sheet St1 and the second sheet St2, and the first plate part 1 are stacked.

Next, in step ST6, the sixth process of performing lamination processing for the laminate SL1 is performed. Here, a laminating apparatus (laminator) is used to integrate the laminate SL1. For example, in the laminator, the laminate SL1 is placed on a heater board in a chamber, and the laminate SL1 is heated to about 100°C to 200°C while the inside of the chamber is decompressed to about 50 Pa to 150 Pa. At this time, the first sheet St1 and the second sheet St2 are brought into a state of being flowable by heating. In this state, the laminate SL1 is pressed by a diaphragm sheet or the like in the chamber, so that the laminate SL1 is brought into a state of being integrated. This causes a state where the solar cell section 3pv is covered with the first sealing material 3fi, and the second sealing material 3se is filled in the annular third region A3 closer to the through hole 1h than the first sealing material 3fi. In this lamination processing, for example, integration of the laminate SL1 is performed under vacuum. Therefore, for example, air bubbles are unlikely to enter each of the first sheet St1 and the second sheet St2 in the molten state. As a result, pressing of the first sheet St1 and the second sheet St2 in the molten state allows the first sealing material 3fi and the second sealing material 3se to be in a dense state with few vacancies. As a result, for example, a water barrier property by the first sealing material 3fi and the second sealing material 3se may be improved.

Next, in step ST7, the seventh process of mounting the terminal box 4 is performed. Here, for example, as shown in Fig. 11, the terminal box 4 is mounted on the second face 1f2 of the first plate part 1, in the laminate SL1 integrated in the step ST6. At this time, for example, after the second end part 3t2 of the wiring material 3t is connected to a terminal in the terminal box 4, a resin such as silicone sealant is used to fix the terminal box 4 to the second face 1f2 of the first plate part 1. At this time, for example, by fitting the protrusion 4p of the terminal box 4 into the through hole 1h, positional alignment of the terminal box 4 with the second face 1f2 of the first plate part 1 is performed easily. Further, at this time, the output wiring 5 may be connected to the terminal box 4 in advance, or may be connected to the terminal box 4 later. As described above, the solar cell module 100 is manufactured.

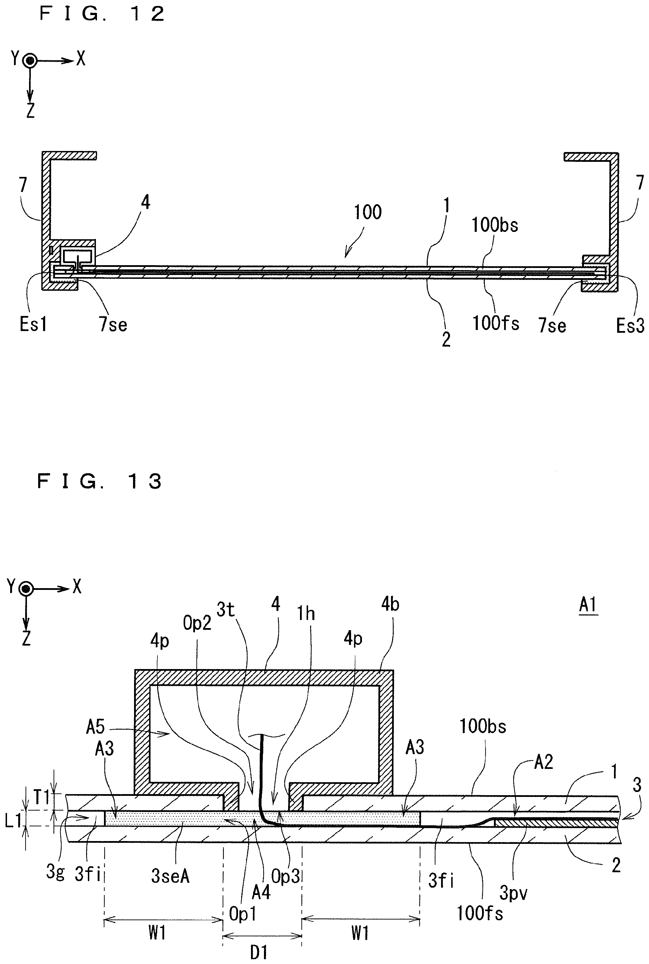

Next, in step ST8, the eighth process of mounting a frame 7 to the solar cell module 100 is performed. Here, for example, as shown in Fig. 12, the frame 7 made of aluminum is mounted to the four end faces Es1, Es2, Es3, and Es4 of the solar cell module 100. At this time, a sealing material 7se having an excellent water barrier property, such as a butyl resin, is filled between the frame 7 and the end faces Es1, Es2, Es3, and Es4. In this way, the solar cell module 100 mounted with the frame 7 is completed.

### <1-3. Summary of First Embodiment>

In the solar cell module 100 according to the first embodiment, for example, in the gap 3g between the first plate part 1 and the second plate part 2, the second sealing material 3se is filled in the annular third region A3 including the first opening Op1, and the periphery thereof, that opens to the fourth region A4 between the through hole 1h and the second plate part 2. As a result, for example, in a path leading to the solar cell section 3pv from the second opening Op2 that opens toward a side opposite to the second plate part 2 in the through hole 1h, the narrowed first opening Op1 may be sealed with the second sealing material 3se having a high water barrier property. Therefore, entry of moisture or the like from the outside of the solar cell module 100 via the through hole 1h of the first plate part 1 toward the solar cell section 3pv may be reduced. Therefore, long-term reliability of the solar cell module 100 may be enhanced.

### <2. Other Embodiments>

The present disclosure is not limited to the above-described first embodiment, and various modifications and improvements are possible without departing from the subject matter of the present disclosure.

### <2-1. Second Embodiment>

In the first embodiment above, for example, the second sealing material 3se may be filled not only in the third region A3 as the annular region, but also in the fourth region A4. Specifically, for example, as shown in Fig. 13, the second sealing material 3se may be changed to a second sealing material 3seA positioned over a fourth region A4 between a through hole 1h and a second plate part 2 from a third region A3 as an annular region. In this case, for example, moisture or the like is unlikely to enter from outside toward a solar cell section 3pv via the through hole 1h of a first plate part 1. As a result, long-term reliability of the solar cell module 100 may be enhanced.

### <2-2. Third Embodiment>

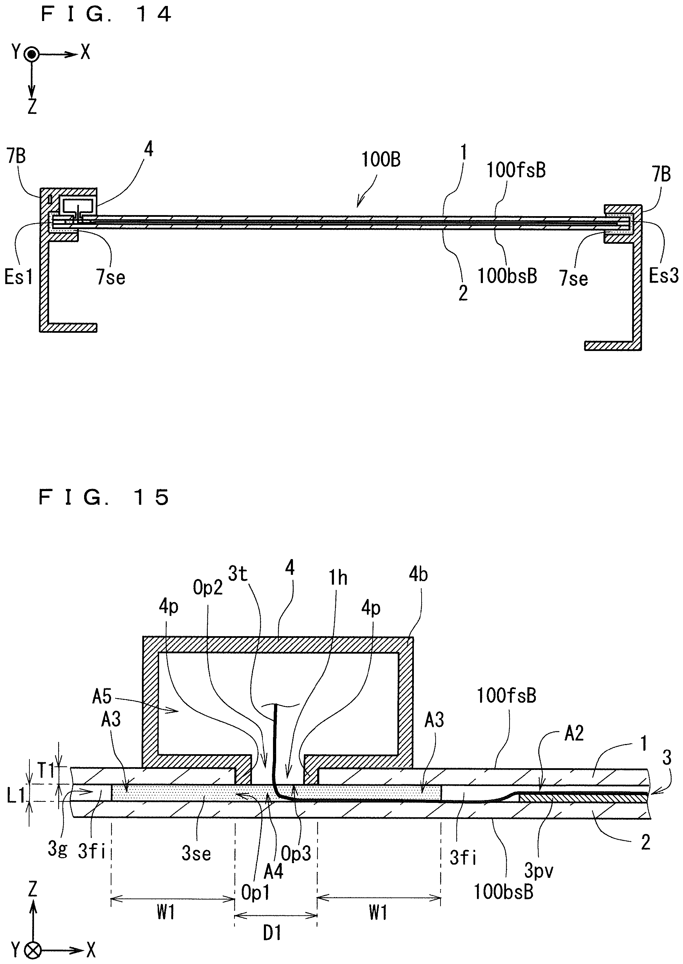

In each of the embodiments above, for example, as shown in Figs. 14 and 15, a board surface on the -Z direction side of the first plate part 1 may be a front surface 100fsB to be mainly irradiated with external light such as sunlight, and a board surface on the +Z direction side of the second plate part 2 may be a back surface 100bsB. At this time, it suffices that the first plate part 1 has a light-transmitting property for light having a wavelength in a specific range. Further, at this time, the second plate part 2 may have a light-transmitting property for light having a wavelength in a specific range, or may not have a light-transmitting property to light having a wavelength in a specific range. In other words, in the first to third embodiments, it suffices that at least one of the first plate part 1 and the second plate part 2 has a light-transmitting property for light having a wavelength in a specific range. Further, in the third embodiment, for example, as shown in Fig. 14, a terminal box 4 may be positioned on the front surface 100fsB. Then, for example, as shown in Fig. 14, four end faces Es1, Es2, Es3, and Es4 may be mounted with a frame 7B having such a shape as a frame 7 is turned upside down.

### <3. Other>

In each of the embodiments above, for example, there may be one through hole 1h in the first plate part 1, and two wiring materials 3t may be positioned in a state of extending from the inside of the gap 3g to the outside of the gap 3g via this one through hole 1h. At this time, a diameter of the one through hole 1h may simply be increased in order not to cause a short circuit due to contact of the two wiring materials 3t.

In each of the embodiments above, for example, in the gap 3g, the first sealing material 3fi may be present not only between the first plate part 1 and the solar cell section 3pv, but also between the second plate part 2 and the solar cell section 3pv. In this case, in manufacturing the solar cell module, for example, a first one of first sheets St1, the solar cell section 3pv, and a second one of the first sheets St1 may simply be stacked in this described order on the second plate part 2.

In each of the embodiments above, for example, in a region other than the region where the second sealing material 3se is present in the gap 3g, the solar cell section 3pv may be appropriately positioned as long as it is within a range that can be covered with the first sealing material 3fi. For example, in a case where the solar cell section 3pv includes a plurality of solar cell elements, it suffices that the plurality of solar cell elements are positioned avoiding a position of the second sealing material 3se.

Needless to say that all or part constituting each of the embodiments and the various modified examples can be combined as appropriate in a range not inconsistent.

### Explanation of Reference Signs

1: first plate part
1h: through hole
2: second plate part
3fi: first sealing material
3g: gap
3pv: solar cell section
3se: second sealing material
3t: wiring material
4: terminal box
4p: protrusion
5: output wiring
100: solar cell module
A1: first region
A2: second region
A3: third region
A4: fourth region
A5: fifth region
Op1: first opening
Op2: second opening
Op3: third opening

## Claims

1. A solar cell module comprising:
a first plate part;
a second plate part positioned in a state of facing the first plate part;
a solar cell section positioned in a gap between the first plate part and the second plate part;
a wiring material electrically connected to the solar cell section and positioned from an inside of the gap to an outside of the gap via a through hole that is present in the first plate part;
a first sealing material positioned in a region covering the solar cell section in the gap; and
a second sealing material that is in a state of being filled in an annular region that is closer to the through hole than the first sealing material in the gap and surrounds an entire periphery of the through hole in plan perspective view, the second sealing material having a higher water barrier property than the first sealing material, wherein
at least one of the first plate part and the second plate part has a light-transmitting property for light having a wavelength in a specific range.

2. The solar cell module according to claim 1, wherein a radial thickness of the annular region is larger than a length of the through hole.

3. The solar cell module according to claim 1 or 2, wherein the second sealing material is positioned over a region between the through hole and the second plate part from the annular region.

4. The solar cell module according to any one of claims 1 to 3, wherein an area of a first opening that opens toward a region between the through hole and the second plate part in the gap is smaller than an area of a second opening that opens toward a side opposite to the second plate part in the through hole.

5. The solar cell module according to any one of claims 1 to 4, further comprising a terminal box positioned on a surface on a side opposite to the second plate part in the first plate part and including a protrusion positioned in a state of being fitted in the through hole.
